# EUROPEAN PATENT APPLICATION

(11) **EP 1 868 308 A2**
(43) Date of publication of application: **19.12.2007**
(21) Application number: 07108862.9
(22) Date of filing: 24.05.2007
(51) Int. Cl.: H04H 1/00

(54) **Terrestrial-digital multimedia broadcasting receiver**

(30) Priority: 01.06.2006 KR 20060049197
(71) Applicant: Integrant Technologies Inc., Seongnam-si, Gyoenggi-do 463-810 (KR)
(72) Inventor: Kim, Bonkee, Gyeonggi-do (KR); Cho, Youngho, Gyeonggi-do (KR); Kim, Bo-Eun, Gyeonggi-do (KR)
(74) Representative: Kastel, Stefan

(57) **Abstract**

Provided is a terrestrial-digital multimedia broadcasting (T-DMB) receiver. A T-DMB receiver comprises a low noise amplifier amplifying a radio frequency (RF) signal for T-DMB, a down-conversion mixer directly down converting the RF signal amplified at the low noise amplifier into a baseband signal, a down frequency oscillator generating a frequency for the down-conversion and supplying the frequency to the down-conversion mixer, and a filtering unit filtering the baseband signal output from the down-conversion mixer.

## Description

### BACKGROUND OF THE INVENTION

### Field of the Invention

The present invention relates to a receiver, and more particularly, a terrestrial-digital multimedia broadcasting (T-DMB) receiver.

### Description of the Background Art

A conventional receiver using a super-heterodyne mode receives a radio frequency (RF) signal at a RF band, converts the RF signal into an intermediate frequency (IF) signal at an IF band, and repeatedly converts the IF signal into a baseband signal at a baseband.

Due to the repeated frequency conversions performed in the receiver using the super-heterodyne mode, a nonlinear characteristic, intermodulation distortions, and parasitic components may be generated in the receiver.

Thus, the receiver uses a surface acoustic wave (SAW) filter disposed outside the receiver to remove the intermodulation distortions and the parasitic components, and consequently, the manufacturing cost often increases.

In order to overcome such a limitation, a conventional receiver using a low IF mode has been introduced. The receiver using the low IF mode uses an image removing filter to remove an image. However, it is generally difficult to completely remove the image using the image removing filter. Thus, the sensitivity of the receiver may deteriorate, and an image band limitation may arise due to a discordance of the in-phase and the quadrature-phase (I/Q).

The above-described receiver receives a signal mixed with a noise signal through an antenna of a terrestrial-digital multimedia broadcasting (T-DMB) receiver. A degree of attenuation of the signal may differ according to a channel through which the signal is transmitted.

Thus, an automatic gain controller (AGC) is used to control the received signal to maintain a uniform magnitude.

However, for a signal at a certain frequency band, an information contained signal section is not often consecutive, and an information contained section and a null section that does not contain information coexist. The magnitude of the signal at the null section is usually less than that at the information contained section.

Thus, if the AGC operates at the null section, the amplification gain of an amplifier at the null section increases. The increased amplification gain is often maintained even at the information contained section for a certain period after the null section. As a result, it is often difficult to uniformly maintain the magnitude of the signal at the received information contained section.

### SUMMARY OF THE INVENTION

Accordingly, one embodiment of the present invention is directed to provide a T-DMB receiver that can allow easy channel selection, be decreased in size, and reduce the amount of power consumption, without requiring a SAW filter formed outside the receiver.

Another embodiment of the present invention is directed to provide a T-DMB receiver that can uniformly maintain the magnitude of a received RF signal for T-DMB.

A T-DMB receiver according to an embodiment of the present invention comprises a low noise amplifier amplifying a RF signal for T-DMB, a down-conversion mixer directly down converting the RF signal amplified at the low noise amplifier into a baseband signal, a down-frequency oscillator generating a frequency for the down-conversion and supplying the frequency to the down-conversion mixer, and a filtering unit filtering the baseband signal output from the down-conversion mixer.

Consistent with the embodiment of the present invention, the filtering unit may comprise a filter filtering the baseband signal output from the down-conversion mixer, and a variable gain amplifier amplifying the baseband signal output from the filter.

Consistent with the embodiment of the present invention, the T-DMB receiver may further comprise an AGC controlling amplification gains of the low noise amplifier and the variable gain amplifier. The AGC may transmit a gain control signal to the low noise amplifier and the variable gain amplifier according to the magnitude of the RF signal, and the gain control signal may be controlled by a null control signal based on a null signal comprised in the RF signal.

Consistent with the embodiment of the present invention, the null control signal may control a signal level of the gain control signal to maintain the signal level uniformly at the null signal section comprised in the RF signal.

Consistent with the embodiment of the present invention, the signal level may be a signal level of the gain control signal before the null signal comprised in the RF signal is received.

A T-DMB receiver according to another embodiment of the present invention comprises a low noise amplifier amplifying a RF signal for T-DMB, an in-phase down-conversion mixer directly down converting the amplified RF signal into an in-phase baseband signal of an I-channel, a quadrature-phase down-conversion mixer directly down converting the amplified RF signal into a quadrature-phase baseband signal of a Q-channel, a down frequency oscillator generating an in-phase frequency and a quadrature-phase frequency for the down-conversion and supplying the in-phase frequency to the in-phase down-conversion mixer and the quadrature-phase frequency to the quadrature-phase down-conversion mixer, an in-phase filtering unit filtering the in-phase baseband signal of the I-channel output from the in-phase down-conversion mixer, and a quadrature-phase filtering unit filtering the quadrature-phase baseband signal of the Q-channel output from the quadrature-phase down-conversion mixer.

Consistent with the other embodiment of the present invention, the in-phase filtering unit may comprise an in-phase filter filtering the in-phase baseband signal of the I-channel output from the in-phase down-conversion mixer, and an in-phase amplifier amplifying the in-phase baseband signal of the I-channel output from the in-phase filter, and the quadrature-phase filtering unit may comprise a quadrature-phase filter filtering the quadrature-phase baseband signal of the Q-channel output from the quadrature-phase down-conversion mixer, and a quadrature-phase amplifier amplifying the quadrature-phase baseband signal of the Q-channel output from the quadrature-phase filter.

Consistent with the other embodiment of the present invention, the T-DMB receiver may further comprise an AGC controlling amplification gains of the low noise amplifier, the in-phase amplifier, and the quadrature-phase amplifier. The the AGC may transmit a gain control signal to the low noise amplifier, the in-phase amplifier, or the quadrature-phase amplifier according to the magnitude of the RF signal, and the gain control signal may be controlled by a null control signal based on a null signal comprised in the RF signal.

Consistent with the other embodiment of the present invention, the null control signal may control a signal level of the gain control signal to maintain the signal level uniformly at the null signal section comprised in the RF signal.

Consistent with the other embodiment of the present invention, the signal level may be a signal level of the gain control signal before the null signal comprised in the RF signal is received.

### BRIEF DESCRIPTION OF THE DRAWINGS

The invention will be described in detail with reference to the following drawings in which like numerals refer to like elements.

FIG. 1 illustrates a simplified block diagram of a T-DMB receiver according to a first embodiment of the present invention;

FIG. 2 illustrates a simplified block diagram of a T-DMB receiver according to a modified embodiment of the first embodiment of the present invention;

FIG. 3 illustrates a simplified block diagram of a T-DMB receiver according to a second embodiment of the present invention;

FIG. 4 illustrates a simplified block diagram of a T-DMB receiver according to a modified embodiment of the second embodiment of the present invention; and

FIG. 5 illustrates a RF signal comprising a null section and a null control signal at a T-DMB receiver according to an embodiment of the present invention.

### DETAILED DESCRIPTION OF EMBODIMENTS

Various embodiments of the present invention will be described in a more detailed manner with reference to the drawings.

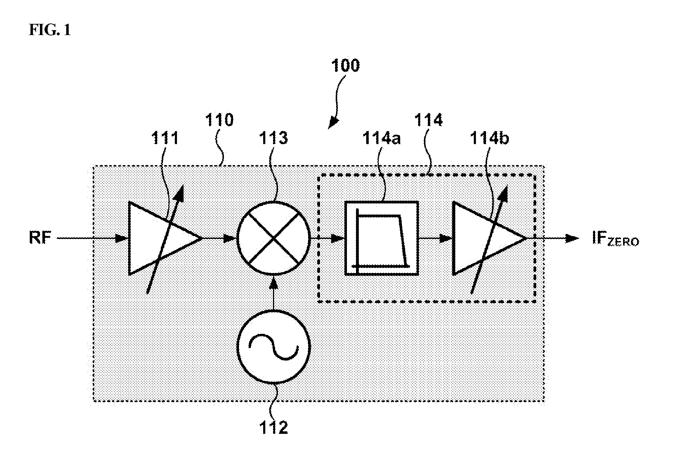

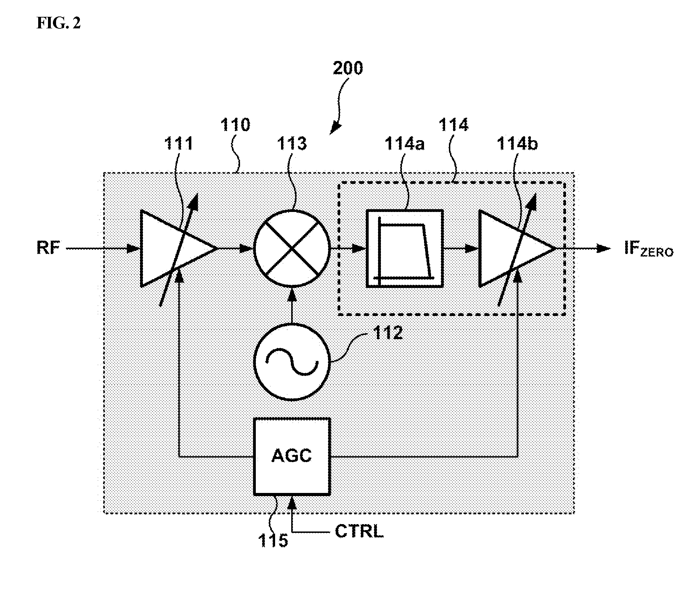

FIG. 1 illustrates a simplified block diagram of a T-DMB receiver 100 according to a first embodiment of the present invention, and FIG. 2 illustrates a simplified block diagram of a T-DMB receiver 200 according to a modified embodiment of the first embodiment of the present invention.

Referring to FIG. 1, the receiver 100 directly down converts a RF signal for T-DMB into a baseband signal IF_{ZERO}.

That is, the receiver 100 comprises a low noise amplifier 111, a down frequency oscillator 112, a down-conversion mixer 113, and a filtering unit 114.

The filtering unit 114 may comprise a filter 114a and a variable gain amplifier 114b.

An output terminal of the low noise amplifier 111 is coupled to a first input terminal of the down-conversion mixer 113.

An output terminal of the down frequency oscillator 112 is coupled to a second input terminal of the down-conversion mixer 113.

An output terminal of the down-conversion mixer 113 is coupled to an input terminal of the filter 114a.

An output terminal of the filtering unit 114 is coupled to an input terminal of the variable gain amplifier 114b.

The output terminal of the down-conversion mixer 113 may be coupled to the input terminal of the variable gain amplifier 114b and an output terminal of the variable gain amplifier 114b may be coupled to the input terminal of the filter 114a according to various design modifications.

The RF signal for T-DMB is transmitted to an input terminal of the low noise amplifier 111.

The low noise amplifier 111 suppresses a noise and amplifies the RF signal received at the input terminal of the low noise amplifier 111.

The low noise amplifier 111 may have a structure capable of gain controlling.

The down frequency oscillator 112 generates a frequency for the down-conversion.

The down-conversion mixer 113 mixes the RF signal amplified at the low noise amplifier 111 with the frequency generated at the down frequency oscillator 112, and down converts the mixed signal into the baseband signal.

The filtering unit 114 filters a low frequency band of the baseband signal output from the down-conversion mixer 113.

The disposition of the filter 114a and the variable gain amplifier 114b in the filtering unit 114 may be changed by implementing one of the cases including: filtering the low frequency band of the baseband signal output from the down-conversion mixer 113 using the filter 114a and then amplifying the filtered baseband signal using the variable gain amplifier 114b; and amplifying the baseband signal output from the down-conversion mixer 113 using the variable gain amplifier 114b and then filtering the low frequency band of the amplified baseband signal using the filter 114a.

The variable gain amplifier 114b may have a structure capable of gain controlling.

Because the T-DMB receiver 100 according to the first embodiment of the present invention has an advantage of using the direct down-conversion mode, it is generally easy to design the filter 114a even when a large value of adjacent channel rejection (ACR) is demanded between adjacent channels. When it is easy to design a filter, a receiver that provides easier channel selection can be manufactured.

The receiver 100 can be formed to maintain the performance, be manufactured at low costs, be decreased in overall size, and be easily integrated into a single chip by forming the filter 114a without requiring a SAW filter formed outside the receiver 100.

Furthermore, for a signal at a certain frequency band, an information contained signal section is often not consecutive, and an information contained section and a null section that does not contain information coexist.

The magnitude of the signal at the null section is usually smaller than that at the information contained section. Thus, the amplification gain of the low noise amplifier 111 or the variable gain amplifier 114b at the null section increases. The increased amplification gain is often maintained even at the information contained section after the null section. As a result, it is often difficult for an adequate amplification to take place.

In order to overcome such a limitation, the T-DMB receiver 200 according to the modified embodiment of the first embodiment of the present invention further comprises a gain controller 115 (e.g., an AGC, and referred to as AGC herein below) in addition to the T-DMB receiver 100 according to the first embodiment of the present invention.

The AGC 115 transmits a gain control signal to the low noise amplifier 111 or the variable gain amplifier 114b. The gain control signal uniformly maintains a gain of the low noise amplifier 111 or the variable gain amplifier 114b according to the magnitude of the RF signal received at the receiver 200.

The gain control signal is controlled by a null control signal CTRL according to the null section of the RF signal received at the receiver 200.

That is, the null control signal CTRL controls the gain control signal based on the null section, and the gain control signal controls the gain of the low noise amplifier 111 or the variable gain amplifier 114b according to the magnitude of the RF signal.

Although the null control signal CTRL is illustrated as being input from the outside of the receiver 200, the null control signal CTRL may be generated from the inside of the receiver 200.

The gain of the low noise amplifier 111 or the variable gain amplifier 114b is uniformly maintained by the gain control signal and the null control signal CTRL.

Thus, null control signal CTRL controls the amplification gain at the null section to not to increase abnormally by: interrupting the amplification gain control of the low noise amplifier 111 or the variable gain amplifier 114b by the AGC 115 of the receiver 200 while a null signal is being received; or maintaining a uniform gain control signal or a gain control signal prior to receiving a null symbol.

The null control signal CTRL may interrupt the amplification gain control by the gain control signal only at the null section or may uniformly maintain a certain gain control signal or a gain control signal prior to receiving the null symbol in order to control the gain control signal to prevent an abnormal increase of the amplification gain at the null section.

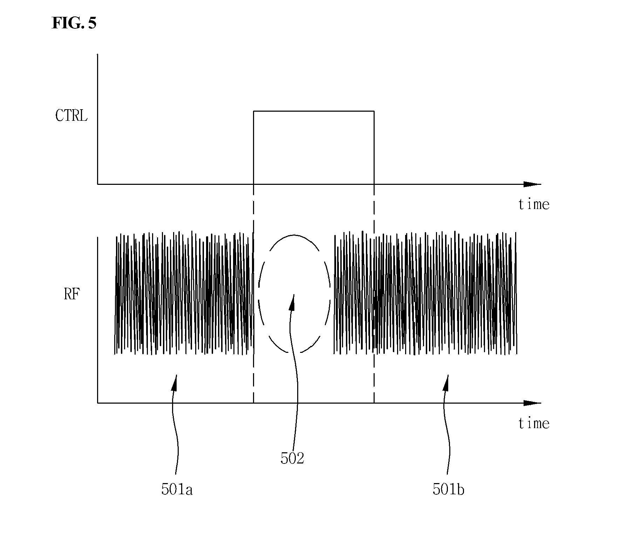

The null control signal CTRL is described in more detail in FIG. 5.

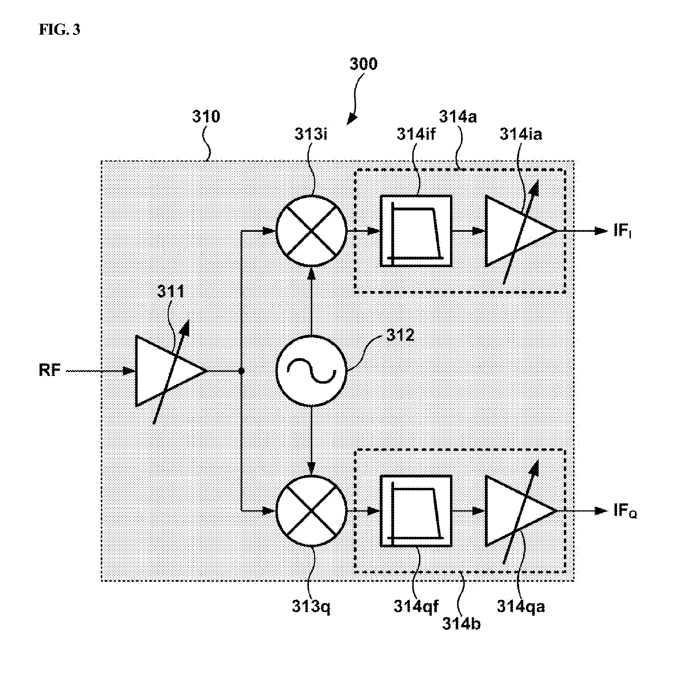

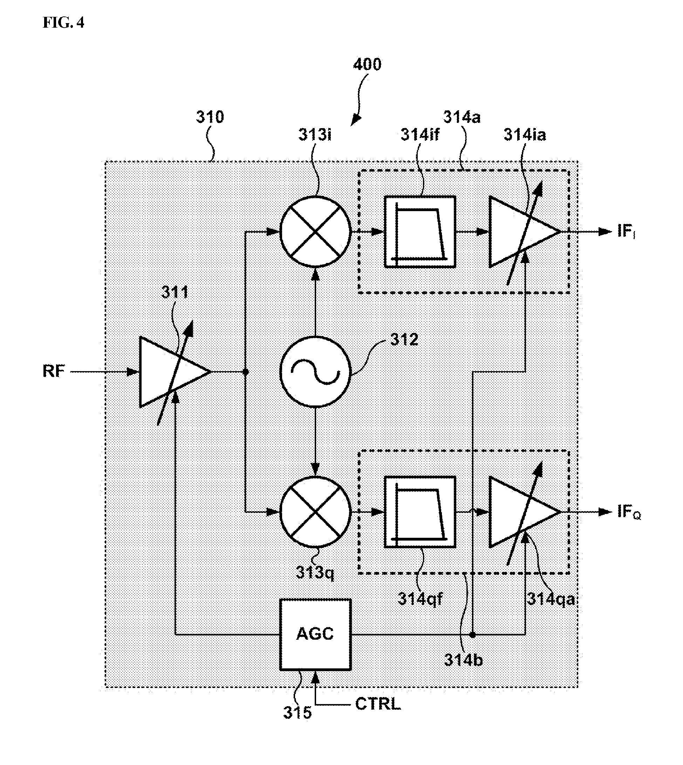

FIG. 3 illustrates a simplified block diagram of a T-DMB receiver 300 according to a second embodiment of the present invention, and FIG. 4 illustrates a simplified block diagram of a T-DMB receiver 400 according to a modified embodiment of the second embodiment of the present invention.

Referring to Fig. 3, the receiver 300 according to the second embodiment of this invention directly down converts a RF signal for T-DMB into an in-phase baseband signal IF_{I} of an I-channel and a quadrature-phase baseband signal IF_{Q} of a Q-channel, and outputs the down-converted signals.

That is, the receiver 300 comprises a low noise amplifier 311, a down frequency oscillator 312, an in-phase down-conversion mixer 313i, an in-phase filtering unit 314a, a quadrature-phase down-conversion mixer 313q, and a quadrature-phase filtering unit 314b.

The in-phase filtering unit 314a may comprise an in-phase filter 314if and an in-phase variable gain amplifier 314ia.

The quadrature-phase filtering unit 314b may comprise a quadrature-phase filter 314qf and a quadrature-phase variable gain amplifier 314qa.

An output terminal of the low noise amplifier 311 is coupled to a first input terminal of the in-phase down-conversion mixer 313i and a first input terminal of the quadrature-phase down-conversion mixer 313q, separately.

Each output terminal of the down frequency oscillator 312 is coupled to a second input terminal of the in-phase down-conversion mixer 313i and a second input terminal of the quadrature-phase down-conversion mixer 313q.

An output terminal of the in-phase down-conversion mixer 313i is coupled to an input terminal of the in-phase filter 314if.

An output terminal of the in-phase filter 314if is coupled to an input terminal of the in-phase variable gain amplifier 314ia.

The output terminal of the in-phase down-conversion mixer 313i may be coupled to the input terminal of the in-phase variable gain amplifier 314ia and an output terminal of the in-phase variable gain amplifier 314ia may be coupled to the input terminal of the in-phase filter 314if according to various design modifications.

An output terminal of the quadrature-phase down-conversion mixer 313q is coupled to an input terminal of the quadrature-phase filter 314qf.

An output terminal of the quadrature-phase filter 314qf is coupled to an input terminal of the quadrature-phase variable gain amplifier 314qa.

The output terminal of the quadrature-phase down-conversion mixer 313q may be coupled to the input terminal of the quadrature-phase variable gain amplifier 314qa and an output terminal of the quadrature-phase variable gain amplifier 314qa may be coupled to the input terminal of the quadrature-phase filter 314qf according to various design modifications.

The RF signal for T-DMB is transmitted to an input terminal of the low noise amplifier 311.

The low noise amplifier 311 suppresses a noise and amplifies the RF signal received at the input terminal of the low noise amplifier 311.

The low noise amplifier 311 may have a structure capable of gain controlling.

The down frequency oscillator 312 generates an in-phase frequency and a quadrature-phase frequency for the down-conversion.

The in-phase down-conversion mixer 313i mixes the RF signal amplified at the low noise amplifier 311 with the in-phase frequency generated at the down frequency oscillator 312, and down converts the mixed signal into the in-phase baseband signal IF_{I} of the I-channel.

The in-phase filtering unit 314a filters a low frequency band of the in-phase baseband signal IF_{I} of the I-channel output from the in-phase down-conversion mixer 313i.

The disposition of the in-phase filter 314if and the in-phase variable gain amplifier 314ia in the in-phase filtering unit 314a may be changed by implementing one of the cases, including: filtering the low frequency band of the in-phase baseband signal IF_{I} of the I-channel output from the in-phase down-conversion mixer 313i using the in-phase filter 314if and then amplifying the filtered in-phase baseband signal IF_{I} of the I-channel using the in-phase variable gain amplifier 314ia; and amplifying the in-phase baseband signal IF_{I} of the I-channel output from the in-phase down-conversion mixer 313i using the in-phase variable gain amplifier 314ia and then filtering the low frequency band of the amplified in-phase baseband signal IF_{I} of the I-channel using the in-phase filter 314if.

The in-phase variable gain amplifier 314ia may have a structure capable of gain controlling.

The quadrature-phase down-conversion mixer 313q mixes the RF signal amplified at the low noise amplifier 311 with the quadrature-phase frequency generated at the down frequency oscillator 312, and down converts the mixed signal into the quadrature-phase baseband signal IF_{Q} of the Q-channel.

The quadrature-phase filtering unit 314b filters a low frequency band of the quadrature-phase baseband signal IF_{Q} of the Q-channel output from the quadrature-phase down-conversion mixer 313q.

The disposition of the quadrature-phase filter 314qf and the quadrature-phase variable gain amplifier 314qa in the quadrature-phase filtering unit 314b may be changed by implementing one of the cases, including: filtering the low frequency band of the quadratic-phase baseband signal IF_{Q} of the Q-channel output from the quadrature-phase down-conversion mixer 313q using the quadrature-phase filter 314qf and then amplifying the filtered quadrature-phase baseband signal IF_{Q} of the Q-channel using the quadrature-phase variable gain amplifier 314qa; and amplifying the quadrature-phase baseband signal IF_{Q} of the Q-channel output from the quadrature-phase down-conversion mixer 313q using the quadrature-phase variable gain amplifier 314qa and then filtering the low frequency band of the amplified quadrature-phase baseband signal IF_{Q} of the Q-channel using the quadrature-phase filter 314qf.

The quadrature-phase variable gain amplifier 314qa may have a structure capable of gain controlling.

Because the T-DMB receiver 300 according to the second embodiment of the present invention has an advantage of using the direct down-conversion mode, it is generally easy to design the in-phase filter 314if and the quadrature-phase filter 314qf even when a large value of ACR is demanded between adjacent channels. When it is easy to design a filter, a receiver that provides easier channel selection can be manufactured.

The receiver 300 can be formed to maintain the performance, be manufactured at low costs, be decreased in overall size, and be easily integrated into a single chip by forming the in-phase filter 314if and the quadrature-phase filter 314qf without requiring a SAW filter formed outside the receiver 300.

Furthermore, for a signal at a certain frequency band, an information contained signal section is often not consecutive, and an information contained section and a null section that does not contain information coexist.

The magnitude of the signal at the null section is usually smaller than that at the information contained section. Thus, the amplification gain of the low noise amplifier 311, the in-phase variable gain amplifier 314ia, or the quadrature-phase variable gain amplifier 314qa at the null section increases. The increased amplification gain is often maintained even at the information contained section after the null section. As a result, it is often difficult for an adequate amplification to take place.

In order to overcome such a limitation, the T-DMB receiver 400 according to the modified embodiment of the second embodiment of the present invention further comprises an AGC 315 in addition to the T-DMB receiver 300 according to the second embodiment of the present invention.

The AGC 315 transmits a gain control signal to the low noise amplifier 311, the in-phase variable gain amplifier 314ia, or the quadrature-phase variable gain amplifier 314qa. The gain control signal uniformly maintains a gain of the low noise amplifier 311, the in-phase variable gain amplifier 314ia, or the quadrature-phase variable gain amplifier 314qa according to the magnitude of the RF signal received at the receiver 400.

The gain control signal is controlled by a null control signal CTRL according to the null section of the RF signal received at the receiver 400.

That is, the null control signal CTRL controls the gain control signal based on the null section, and the gain control signal controls the gain of the low noise amplifier 311, the in-phase variable gain amplifier 314ia, or the quadrature-phase variable gain amplifier 314qa according to the magnitude of the RF signal.

Although the null control signal CTRL is illustrated as being input from the outside of the receiver 400, the null control signal CTRL may be generated from the inside of the receiver 400.

The gain of the low noise amplifier 311, the in-phase variable gain amplifier 314ia, or the quadrature-phase variable gain amplifier 314qa is uniformly maintained by the gain control signal and the null control signal CTRL.

Thus, null control signal CTRL controls the amplification gain at the null section to not to increase abnormally by: interrupting the amplification gain control of the low noise amplifier 311, the in-phase variable gain amplifier 314ia, or the quadrature-phase variable gain amplifier 314qa by the AGC 315 of the receiver 400 while a null signal is being received; or maintaining a uniform gain control signal or a gain control signal prior to receiving a null symbol.

The null control signal CTRL may interrupt the amplification gain control by the gain control signal only at the null section or may uniformly maintain a certain gain control signal or a gain control signal prior to receiving the null symbol in order to control the gain control signal to prevent an abnormal increase of the amplification gain at the null section.

The null control signal CTRL is described in more detail in FIG. 5.

FIG. 5 illustrates a RF signal comprising a null section and a null control signal at the T-DMB receivers 200 and 400 according to an embodiment of the present invention.

FIG. 5 is to describe the embodiments of the present invention illustrated in FIG. 2 and FIG. 4, and can be commonly applied to the embodiments illustrated in FIG. 2 and FIG. 4.

In the following descriptions, the embodiment of the present invention illustrated in FIG. 2 is used as a reference.

The received RF signal for T-DMB comprises information sections 501a and 501b and a null section 502.

The gain control signal is supplied to the low noise amplifier 111 and the variable gain amplifier 114b. The gain control signal controls the amplification gain of the low noise amplifier 111 and the variable gain amplifier 114b according to the intensity of the received RF signal.

The null control signal CTRL controls the gain control signal based on the null signal that is comprised in the received RF signal, and the gain control signal is transmitted to the low noise amplifier 111 and the variable gain amplifier 114b.

The null control signal CTRL may be generated from the inside of the receiver 200 or be input from the outside of the receiver 200.

The null control signal CTRL turns on at a range between before and after the beginning of the null section 502, and turns off at a range between before and after the ending of the null section 502.

It is obvious that the null control signal CTRL controlling the gain control signal can be controlled by other types of methods in addition to the turning on and off method.

If the null control signal CTRL turns on just before the information section 501a or 501b ends, the null control signal CTRL stops the amplification gain control by the gain control signal or controls the gain control signal to become a certain gain control signal.

In particular, the null control signal CTRL may maintain the gain control signal at a certain uniform signal level.

The certain uniform signal level may include a signal level of the gain control signal just before the end of the information sections 501A and 501B.

Accordingly, the null control signal CTRL controlling the gain control signal allows reducing an abnormal increase of the amplification gain at the null section 502.

According to various embodiments of the present invention, the T-DMB receiver can provide easy channel selection, be decreased in size, and reduce the amount of power consumption, without requiring the SAW filter formed outside the receiver.

According to various embodiments of the present invention, the T-DMB receiver can uniformly maintain the magnitude of the received RF signal for T-DMB.

The invention being thus described, it will be obvious that the same may be varied in many ways. Such variations are not to be regarded as a departure from the spirit and scope of the invention and all such modifications as would be obvious to one skilled in the art are intended to be included within the scope of the following claims.

## Claims

1. A terrestrial-digital multimedia broadcasting (T-DMB) receiver comprising:
a low noise amplifier amplifying a radio frequency (RF) signal for T-DMB;
a down-conversion mixer directly down converting the RF signal amplified at the low noise amplifier into a baseband signal;
a down frequency oscillator generating a frequency for the down-conversion and supplying the frequency to the down-conversion mixer; and
a filtering unit filtering the baseband signal output from the down-conversion mixer.

2. The T-DMB receiver of claim 1, wherein the filtering unit comprises:
a filter filtering the baseband signal output from the down-conversion mixer; and
a variable gain amplifier amplifying the baseband signal output from the filter.

3. The T-DMB receiver of claim 1, further comprising an automatic gain controller (AGC) controlling amplification gains of the low noise amplifier or the variable gain amplifier, wherein the AGC transmits a gain control signal to the low noise amplifier or the variable gain amplifier according to the magnitude of the RF signal, and the gain control signal is controlled by a null control signal based on a null signal comprised in the RF signal.

4. The T-DMB receiver of claim 3, wherein the null control signal controls a signal level of the gain control signal to maintain the signal level uniformly at the null signal section comprised in the RF signal.

5. The T-DMB receiver of claim 4, wherein the signal level is a signal level of the gain control signal before the null signal comprised in the RF signal is received.

6. A T-DMB receiver comprising:
a low noise amplifier amplifying a RF signal for T-DMB;
an in-phase down-conversion mixer directly down converting the amplified RF signal into an in-phase baseband signal of an I-channel;
a quadrature-phase down-conversion mixer directly down converting the amplified RF signal into a quadrature-phase baseband signal of a Q-channel;
a down frequency oscillator generating an in-phase frequency and a quadrature-phase frequency for the down-conversion and supplying the in-phase frequency to the in-phase down-conversion mixer and the quadrature-phase frequency to the quadrature-phase down-conversion mixer;
an in-phase filtering unit filtering the in-phase baseband signal of the I-channel output from the in-phase down-conversion mixer; and
a quadrature-phase filtering unit filtering the quadrature-phase baseband signal of the Q-channel output from the quadrature-phase down-conversion mixer.

7. The T-DMB receiver of claim 6, wherein the in-phase filtering unit comprises:
an in-phase filter filtering the in-phase baseband signal of the 1-channel output from the in-phase down-conversion mixer; and
an in-phase amplifier amplifying the in-phase baseband signal of the I-channel output from the in-phase filter,
wherein the quadrature-phase filtering unit comprises:
a quadrature-phase filter filtering the quadrature-phase baseband signal of the Q-channel output from the quadrature-phase down-conversion mixer; and
a quadrature-phase amplifier amplifying the quadrature-phase baseband signal of the Q-channel output from the quadrature-phase filter.

8. The T-DMB receiver of claim 6, further comprising an AGC controlling amplification gains of the low noise amplifier, the in-phase amplifier, and the quadrature-phase amplifier, wherein the AGC transmits a gain control signal to the low noise amplifier, the in-phase amplifier, or the quadrature-phase amplifier according to the magnitude of the RF signal, and the gain control signal is controlled by a null control signal based on a null signal comprised in the RF signal.

9. The T-DMB receiver of claim 8, wherein the null control signal controls a signal level of the gain control signal to maintain the signal level uniformly at the null signal section comprised in the RF signal.

10. The T-DMB receiver of claim 9, wherein the signal level is a signal level of the gain control signal before the null signal comprised in the RF signal is received.
